# EUROPÄISCHE PATENTSCHRIFT

(11) **EP 3 224 849 B1**
(45) Veröffentlichungstag und Bekanntmachung des Hinweises auf die Patenterteilung: **05.05.2021**
(21) Anmeldenummer: 15788332.3
(22) Anmeldetag: 31.10.2015
(51) Int. Cl.: H01H 13/84, G06F 3/01, H03K 17/95, B60W 50/16, H01H 13/85, B60K 37/06, H01H 3/00

(54) **BEDIENEINRICHTUNG UND VERFAHREN ZUM ANSTEUERN VON FUNKTIONSEINHEITEN EINES KRAFTFAHRZEUGS**
OPERATOR CONTROL DEVICE AND METHOD FOR ACTUATING FUNCTIONAL UNITS OF A MOTOR VEHICLE
DISPOSITIF DE COMMANDE ET PROCÉDÉ DE COMMANDE D'UNITÉS FONCTIONNELLES D'UN VÉHICULE AUTOMOBILE

(30) Priorität: 27.11.2014 DE 102014017577
(43) Veröffentlichungstag der Anmeldung: 04.10.2017
(73) Patentinhaber: Audi AG, 85045 Ingolstadt (DE)
(72) Erfinder: WACHINGER, Michael, 86571 Winkelhausen (DE)
(74) Vertreter: Brandt, Kai
(86) Internationale Anmeldenummer: PCT/EP2015/002191
(87) Internationale Veröffentlichungsnummer: WO 2016/082909

(56) Entgegenhaltungen:
- DE-A1- 10 243 600
- DE-A1-102011 018 897
- DE-A1-102011 117 120
- DE-C1- 4 230 950
- US-A- 5 189 390
- US-B1- 6 466 201

## Beschreibung

Die Erfindung betrifft eine Bedieneinrichtung zum Ansteuern von Funktionseinheiten eines Kraftfahrzeugs. Die Bedieneinrichtung weist wenigstens ein Bedienelement auf, welches von einer Bedienperson bewegt werden kann. Die Bedieneinrichtung umfasst des Weiteren einen Aktor, mittels welchem der Bedienperson ein Betätigen des Bedienelements kommuniziert werden kann. Der Aktor umfasst ein Spulenelement und einen relativ zu dem Spulenelement bewegbaren Anker. Des Weiteren betrifft die Erfindung ein Verfahren zum Ansteuern von Funktionseinheiten eines Kraftfahrzeugs.

Die DE 42 30 950 C1 beschreibt einen elektrischen Drucktastenschalter mit einer Drucktaste, welche entgegen einer Rückstellkraft einer Feder betätigt wird. Ein elektromagnetisches Bauteil des Drucktastenschalters wird einerseits als Sensor zur elektrischen Auswertung der Position der Drucktaste verwendet und andererseits als Stellglied, welches eine zusätzliche Bewegung der Drucktaste in Abhängigkeit von einer Schaltfunktion herbeiführt.

Die DE 10 2011 117 120 A1 betrifft ein Schaltbedienfeld für ein Kraftfahrzeug, welches Betätigungsflächen aufweist, auf welche mit einem Finger einer menschlichen Hand eine Bedienkraft ausgeübt werden kann. Um die Bedienkraft zu ermitteln, ist ein Dehnungsmessstreifen vorgesehen. Wird das Bedienen einer Betätigungsfläche festgestellt, so wird einer Bedienperson eine haptische Rückmeldung kommuniziert, indem ein Elektromagnet mit einer Spule und einem darin beweglich angeordneten Anker mit Strom beaufschlagt wird. Daraufhin schlägt der Anker gegen ein Element, dessen Bewegung über einen Stößel auf die Betätigungsfläche übertragen wird. Dies wird vom Finger der Bedienperson als haptische Rückmeldung für das Betätigen der Betätigungsfläche wahrgenommen.

Als nachteilig ist hierbei der Umstand anzusehen, dass das Vorsehen eines Dehnungsmessstreifens zum Erfassen der Bedienkraft aufwendig, kostenintensiv und fehleranfällig ist.

Des Weiteren beschreibt die DE 102 43 600 A1 einen elektrischen Schalter, welcher in Kraftfahrzeugen verwendet werden kann. Wird eine Betätigung des Schalters mittels einer Schalteinrichtung erfasst, so wird eine Spulenwicklung mit Strom beaufschlagt und ein in der Spulenwicklung linear geführter Anker wird in eine Schwingungsbewegung versetzt; bei welcher der Anker gegen den Schalter schlägt. Dies wird von einer Bedienperson als Vibration des Schalters wahrgenommen.

Die DE 10 2009 042 777 A1 beschreibt einen elektromagnetischen Aktor zum Betätigen eines Schalters oder eines Ventils, etwa um einen Durchfluss durch das Ventil einzustellen. Hierbei umfasst der elektromagnetische Aktor eine Spule und einen durch Bestromung der Spule bewegbaren Anker, mit dem ein Stößel verbunden ist. Eine Messvorrichtung zum Bestimmen einer Ankerposition umfasst einen Stromsensor und einen Magnetfeldsensor.

Aufgabe der vorliegenden Erfindung ist es, eine Bedieneinrichtung der eingangs genannten Art mit einem vereinfachten Aufbau und ein vereinfachtes Verfahren der eingangs genannten Art zu schaffen.

Diese Aufgabe wird durch eine Bedieneinrichtung mit den Merkmalen des Patentanspruchs 1 und durch ein Verfahren mit den Merkmalen des Patentanspruchs 10 gelöst. Vorteilhafte Ausgestaltungen mit zweckmäßigen Weiterbildungen der Erfindung sind in den abhängigen Patentansprüchen angegeben.

Bei der erfindungsgemäßen Bedieneinrichtung ist der Anker an dem Bedienelement festgelegt. Zudem umfasst die Bedieneinrichtung eine Auswerteeinrichtung, mittels welcher eine Position des Ankers relativ zu dem Spulenelement erfassbar ist. Dadurch, dass sich mittels der Auswerteeinrichtung die Position des Ankers relativ zu dem Spulenelement erfassen lässt, kann der Aktor als Sensor genutzt werden, welcher das Betätigen des Bedienelements erfasst. Dies führt zu einem besonders einfachen Aufbau der Bedieneinrichtung. Es kann nämlich auf einem separaten Sensor zum Erfassen des Betätigens des Bedienelements verzichtet werden. Des Weiteren sind so die Möglichkeiten von Fehlern reduziert, da besonders wenige Bauteile zum Bereitstellen der Bedieneinrichtung ausreichend sind.

Die Auswerteeinrichtung ist dazu ausgebildet, einen Stromfluss durch das Spulenelement einzustellen, welcher geringer ist als ein zum Bewegen des Ankers einzustellender Stromfluss durch das Spulenelement. Hierbei ist die Auswerteeinrichtung zusätzlich zum Erfassen einer im Bereich des Spulenelements vorhandenen magnetischen Flussdichte ausgebildet. Der geringe Stromfluss durch das Spulenelement sorgt dafür, dass der Anker an einer bestimmten Position relativ zu der Spule verbleibt. Der geringe Stromfluss durch das Spulenelement reicht also nicht aus, den Anker relativ zu dem Spulenelement zu bewegen und so der Bedienperson eine Rückmeldung über das Betätigen des Bedienelements zu kommunizieren. Das Betätigen des Bedienelements und damit das aktive Bewegen des Ankers durch die Bedienperson führt dann jedoch zu einer Veränderung der magnetischen Flussdichte im Bereich des Spulenelements.

Eine Änderung der magnetischen Flussdichte infolge des Bewegens des Ankers relativ zu dem Spulenelement kann besonders einfach und genau festgestellt werden. Auf diese Weise lässt sich also auch die Position des Ankers relativ zu dem Spulenelement besonders einfach und genau erfassen.

Der Anker kann zumindest bereichsweise aus einem magnetischen und/oder magnetisierbaren Material gebildet sein. Hierbei ist die Auswerteeinrichtung zum Erfassen eines Stromflusses durch das Spulenelement ausgebildet. Eine solche induktive Auswertung bei der Nutzung des Aktors als Sensor ist besonders einfach zu realisieren.

Wenn der Anker oder ein Teil des Ankers aus dem magnetisierbaren Material gebildet ist, so können die magnetischen Eigenschaften des Ankers genutzt werden, welche der Anker beim Bestromen des Spulenelements aufgrund des dadurch erzeugten Magnetfelds erhält. Dies macht das Bereitstellen des Ankers besonders kostengünstig.

Die Auswerteeinrichtung kann insbesondere dazu ausgebildet sein, einen getakteten Stromfluss durch das Spulenelement einzustellen, also zeitlich aufeinanderfolgende Strompulse, welche mit Zeitspannen abwechseln, in welchen das Spulenelement nicht bestromt wird. So lässt sich besonders einfach sicherstellen, dass der Stromfluss durch das Spulenelement nicht zu einem Bewegen des Ankers relativ zu dem Spulenelement führt.

r Als weiter vorteilhaft hat es sich gezeigt, wenn die Auswerteeinrichtung dazu ausgebildet ist, eine Betätigungskraft zu ermitteln, welche die Bedienperson zum Bewegen des Bedienelements aufbringt. Dann kann nämlich besonders sicher festgestellt werden, ob die Bedienperson tatsächlich das Bedienelement betätigen will oder das Bedienelement lediglich versehentlich berührt.

Als weiter vorteilhaft hat es sich gezeigt, wenn eine Steuerungseinrichtung vorgesehen ist, welche dazu ausgebildet ist, den Aktor in Abhängigkeit von einem Signal der Auswerteeinrichtung anzusteuern. Erfasst also die Auswerteeinrichtung die Position des Ankers relativ zu dem Spulenelement, so kann sie ein entsprechendes Signal an die Steuerungseinrichtung ausgeben. Dies führt dann wiederum dazu, dass die Steuerungseinrichtung das Spulenelement mit Strom beaufschlagt und so dafür sorgt, dass der Aktor der Bedienperson eine, beispielsweise haptisch erfassbare, Rückmeldung der Betätigung des Bedienelements kommuniziert. Dies macht das Bedienen des Bedienelements für die Bedienperson besonders komfortabel.

Als vorteilhaft hat es sich hierbei gezeigt, wenn die Steuerungseinrichtung dazu ausgebildet ist, den Aktor dann anzusteuern, wenn die Betätigungskraft größer ist als ein vorbestimmter Schwellenwert der Betätigungskraft. So kann besonders einfach dafür gesorgt werden, dass lediglich beim Überschreiten des Schwellenwerts der Betätigungskraft der Bedienperson kommuniziert wird, dass sie das Bedienelement betätigt. Dies macht die Bedieneinrichtung besonders betriebssicher.

Das Spulenelement kann auf einer Seite einer Leiterplatte angeordnet sein, welche einer Seite des Bedienelements zugewandt ist, an welcher der Anker festgelegt ist. Dann braucht kein gesonderter Stator oder dergleichen vorgesehen zu werden, an welchem das Spulenelement angeordnet ist. Dies macht die Bedieneinrichtung besonders einfach und vergleichsweise kompakt.

Eine besonders kompakte Ausbildung der Bedieneinrichtung ist des Weiteren realisierbar, wenn das Spulenelement durch in die Leiterplatte integrierte Leiterbahnen gebildet ist. Dies führt nämlich zu einem besonders geringen Bauraumbedarf des Spulenelements.

Schließlich hat es sich als vorteilhaft gezeigt, wenn die Bedieneinrichtung eine Mehrzahl der Bedienelemente aufweist, welchen ein jeweiliger Aktor zugeordnet ist. Hierbei sind die Bedienelemente in wenigstens einer Reihe angeordnet. Insbesondere bei in Reihen angeordneten Bedienelementen, wie sie beispielsweise in Form von Schalterleisten in Kraftfahrzeugen vorkommen, ist es nämlich für die Bedienperson besonders vorteilhaft, wenn der Bedienperson eine Rückmeldung über die Betätigung des jeweiligen Bedienelements kommuniziert wird.

Bei dem erfindungsgemäßen Verfahren zum Ansteuern von Funktionseinheiten eines Kraftfahrzeugs wird wenigstens ein Bedienelement einer Bedieneinrichtung von einer Bedienperson bewegt. Hierbei wird ein an dem Bedienelement festgelegter Anker eines Aktors der Bedieneinrichtung aufgrund des Bewegens des Bedienelements mitbewegt. Mittels einer Auswerteeinrichtung der Bedieneinrichtung wird eine Position des Ankers relativ zu einem Spulenelement des Aktors erfasst. Mittels der Auswerteeinrichtung wird ein Stromfluss durch das Spulenelement eingestellt, welcher geringer ist als ein zum Bewegen des Ankers einzustellender Stromfluss. Mittels der Auswerteeinrichtung wird eine im Bereich des Spulenelements vorhandene magnetische Flussdichte erfasst. Daraufhin wird der Bedienperson ein Betätigen des Bedienelements mittels des Aktors kommuniziert, indem der Anker relativ zu dem Spulenelement bewegt wird. Bei diesem Verfahren kann der Bedienperson auf besonders einfache Art und Weise eine Rückmeldung zu dem Erfolgtsein des Betätigens des Bedienelements übermittelt oder kommuniziert werden, denn es wird der Aktor zugleich als Sensor genutzt.

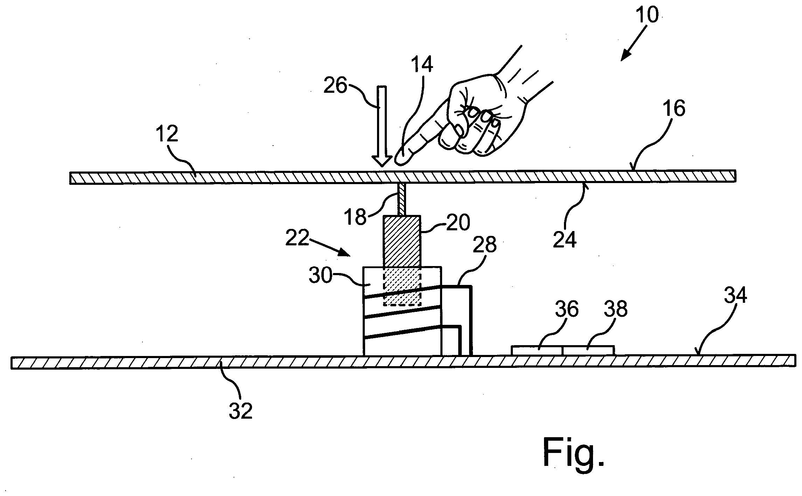

Die vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder in Alleinstellung verwendbar, ohne den Rahmen der Erfindung zu verlassen. Es sind somit auch Ausführungen als von der Erfindung umfasst und offenbart anzusehen, die in der Figur nicht explizit gezeigt oder erläutert sind, jedoch durch separierte Merkmalskombinationen aus den erläuterten Ausführungen hervorgehen und erzeugbar sind. Weitere Vorteile, Merkmale und Einzelheiten der Erfindung ergeben sich aus den Ansprüchen, der nachfolgenden Beschreibung bevorzugter Ausführungsformen sowie anhand der einzigen Zeichnung.

Diese zeigt schematisch ein Bedieneinrichtung zum Ansteuern von Funktionseinheiten eines Kraftfahrzeugs, bei welcher ein mit einem Bedienelement gekoppelter Anker relativ zu einer Spule bewegt wird, wobei ein den Anker und die Spule umfassender Aktor als Sensor zum Erfassen dieser Bewegung genutzt wird.

Eine in der Figur schematisch gezeigte Bedieneinrichtung 10 dient dem Ansteuern von Funktionseinheiten eines Kraftfahrzeugs. Beispielsweise können mittels der Bedieneinrichtung 10 eine Warnblinkanlage oder eine Scheibenheizung an- oder ausgeschaltet werden. Auch kann die Bedieneinrichtung 10 dafür genutzt werden, eine Fahrweise wie beispielsweise eine sportliche Fahrweise, eine defensive Fahrweise oder eine Kraftstoff sparende Fahrweise einzustellen, ein Fahrerassistenzsystem sowie weitere Komfortfunktionen und/oder Sicherheitsfunktionen wie etwa ein elektronisches Stabilitätsprogramm zu aktivieren oder zu deaktivieren.

Hierfür kann die Bedieneinrichtung 10 eine Mehrzahl von Bedienteilen oder Bedienelementen 12 aufweisen, von denen in der Figur eines schematisch gezeigt ist. Derartige Bedienelemente 12 können insbesondere in einer Schalterleiste in einer Reihe angeordnet sein. Die wenigstens eine Schalterleiste kann in einer Instrumententafel, in einer Mittelkonsole, im Bereich einer Türverkleidung oder an einem anderen Innenausstattungsteil des Kraftfahrzeugs angeordnet sein.

Vorliegend kann das Bedienelement 12 betätigt werden, indem eine Bedienperson beispielsweise mit einem Finger 14 eine Kraft auf eine Oberfläche 16 des Bedienelements 12 ausübt und das Bedienelement 12 hierbei verformt. Mit dem Bedienelement 12 ist über einen Schaft 18 ein Anker 20 eines Aktors 22 verbunden. Der Schaft 18 ist hierbei an einer Unterseite 24 des Bedienelements 12 festgelegt. Wird also auf die Oberfläche 16 des Bedienelements 12 die Kraft ausgeübt, welche in der Figur durch einen Pfeil 26 veranschaulicht ist, so bewegt sich ebenfalls der an der Unterseite 24 des Bedienelements 12 angeordnete Anker 20 des Aktors 22.

Bei der in der Figur schematisch gezeigten Bedieneinrichtung 10 ist der Anker 20 linear innerhalb der Wicklungen einer Spule 28 des Aktors 22 bewegbar, welche vorliegend um einen Stator 30 gewickelt ist. In alternativen Ausführungsformen können auch andere Ausgestaltungen eines vorliegend als die Spule 28 ausgebildeten Spulenelements vorgesehen sein.

Auf einer Leiterplatte 32, welche eine dem Bedienelement 12 zugewandte Oberseite 34 aufweist, ist vorliegend eine Auswerteeinrichtung oder Auswerteelektronik 36 angeordnet. Diese Auswerteelektronik 36 ermöglicht es, die Position des Ankers 20 relativ zu der Spule 28 zu bestimmen. Hierfür kann der Anker 20 bereichsweise magnetisch sein, oder es kann zumindest ein Teil des Ankers 20 aus einem magnetisierbaren Material gebildet sein. Wird dann der magnetische oder magnetisierte Anker 20 relativ zu der Spule 28 bewegt, so kann dies anhand eines Stromflusses durch die Spule 28 von der Auswerteelektronik 36 erfasst werden.

Mittels des elektromagnetischen Aktors 22 ist somit insbesondere eine induktive Auswertung der Bewegung des Bedienelements 12 ermöglicht, wobei die Bewegung durch die von dem Finger 14 aufgebrachte Betätigungskraft bewirkt wird.

Die Auswerteelektronik 36 sorgt dafür, dass ein sehr geringer Strom durch die Spule 28 fließt. Dieser sehr geringe Strom bewirkt kein Bewegen des Ankers 20. Der geringe Strom erlaubt es aber, eine Bewegung des Ankers 20 relativ zu der von Strom durchflossenen Spule 28 zu erfassen, welche von der mit dem Finger 14 aufgebrachten Betätigungskraft herrührt. Das von der stromdurchflossenen Spule 28 erzeugte Magnetfeld ändert sich nämlich, wenn der Anker 20 relativ zu der von Strom durchflossenen Spule 28 bewegt wird. Dies kann von der Auswerteelektronik 36 erfasst werden.

In der Auswerteelektronik 36 können Parameter etwa in Form einer Kennlinie gespeichert sein, welche mit der jeweiligen Eindringtiefe des Ankers 20 in die Spule 28 einhergehen. Hierfür kann der bei der jeweiligen Eindringtiefe vorliegende Stromfluss durch die Spule 28 festgestellt werden. Zusätzlich erfasst die Auswerteelektronik 36 die im Bereich der Spule 28 bei der jeweiligen Eindringtiefe vorhandene magnetische Flussdichte.

Anhand der beispielsweise in Form der Kennlinie gespeicherten Parameter kann also auf die von dem Finger 14 aufgebrachte Betätigungskraft rückgeschlossen werden. Überschreitet die Betätigungskraft einen vorbestimmten Schwellenwert, so wird ein Schaltimpuls ausgelöst. Entsprechend wird eine Schaltinformation an eine Steuerungseinrichtung 38 ausgegeben. Diese steuert den Aktor 22 an, indem die Spule 28 mit elektrischem Strom beaufschlagt wird. Dies führt dazu, dass der Anker 20 relativ zu der Spule 28 bewegt wird. Auf diese Weise erhält die Bedienperson eine Rückmeldung, dass die Betätigungskraft ausreichend war, um das Bedienelement 12 zu betätigen. Beispielsweise kann der Aktor 22 dafür sorgen, dass das Bedienelement 12 vibriert. So wird der Bedienperson eine haptische Rückmeldung kommuniziert, dass das Bedienelement 12 betätigt wurde.

Die Auswerteelektronik 36 und die Steuerungseinrichtung 38 können auch in ein elektronisches Bauelement integriert sein, welches dann sowohl dem Erfassen der Position des Ankers 20 relativ zu der Spule 28 dient und auch dem Bestromen der Spule 28 zum Ausgeben der beispielsweise haptischen Rückmeldung an die Bedienperson über das erfolgte Betätigen des Bedienelements 12.

In einer (nicht gezeigten) Ausführungsform kann die Spule 28 des Aktors auch direkt auf der Leiterplatte 32 oder Platine ausgeführt sein, wobei insbesondere auf den Stator 30 verzichtet werden kann. Auch können die Spule 28 bildende Leiterbahnen als Windungen direkt in die Leiterplatte 32 integriert sein. So ergibt sich eine besonders kompakte Ausbildung der Bedieneinrichtung 10.

## Patentansprüche

1. Bedieneinrichtung zum Ansteuern von Funktionseinheiten eines Kraftfahrzeugs, mit wenigstens einem Bedienelement (12), welches von einer Bedienperson bewegbar ist, und mit einem Aktor (22), mittels welchem der Bedienperson ein Betätigen des Bedienelements (12) kommunizierbar ist, wobei der Aktor (22) ein Spulenelement (28) und einen relativ zu dem Spulenelement (28) bewegbaren Anker (20) umfasst, wobei der Anker (20) an dem Bedienelement (12) festgelegt ist und die Bedieneinrichtung (10) eine Auswerteeinrichtung (36) umfasst, mittels welcher eine Position des Ankers (20) relativ zu dem Spulenelement (28) erfassbar ist,
**dadurch gekennzeichnet, dass**
die Auswerteeinrichtung (36) dazu ausgebildet ist, einen Stromfluss durch das Spulenelement (28) einzustellen, welcher geringer ist als ein zum Bewegen des Ankers (20) einzustellender Stromfluss, wobei die Auswerteeinrichtung (36) zum Erfassen einer im Bereich des Spulenelements (28) vorhandenen magnetischen Flussdichte ausgebildet ist.

2. Bedieneinrichtung nach Anspruch 1,
**dadurch gekennzeichnet, dass**
der Anker (20) zumindest bereichsweise aus einem magnetischen und/oder magnetisierbaren Material gebildet ist, wobei die Auswerteeinrichtung (36) zum Erfassen eines Stromflusses durch das Spulenelement (28) ausgebildet ist.

3. Bedieneinrichtung nach Anspruch 1 oder 2,
**dadurch gekennzeichnet, dass**
die Auswerteeinrichtung (36) dazu ausgebildet ist, einen getakteten Stromfluss durch das Spulenelement (28) einzustellen.

4. Bedieneinrichtung nach einem der Ansprüche 1 bis 3,
**dadurch gekennzeichnet, dass**
die Auswerteeinrichtung (36) dazu ausgebildet ist, eine Betätigungskraft zu ermitteln, welche die Bedienperson zum Bewegen des Bedienelements (12) aufbringt.

5. Bedieneinrichtung nach einem der Ansprüche 1 bis 4,
**gekennzeichnet durch**
eine Steuerungseinrichtung (38) zum Ansteuern des Aktors (22) in Abhängigkeit von einem Signal der Auswerteeinrichtung (36).

6. Bedieneinrichtung nach Anspruch 5 in dessen Rückbezug auf Anspruch
**dadurch gekennzeichnet, dass**
die Steuerungseinrichtung (38) dazu ausgebildet ist, den Aktor (22) anzusteuern, wenn die Betätigungskraft größer ist als ein vorbestimmter Schwellenwert der Betätigungskraft.

7. Bedieneinrichtung nach einem der Ansprüche 1 bis 6,
**dadurch gekennzeichnet, dass**
das Spulenelement (28) auf einer Seite (34) einer Leiterplatte (32) angeordnet ist, welche einer Seite (24) des Bedienelements (12) zugewandt ist, an welcher der Anker (20) festgelegt ist.

8. Bedieneinrichtung nach Anspruch 7,
**dadurch gekennzeichnet, dass**
das Spulenelement (28) durch in die Leiterplatte (32) integrierte Leiterbahnen gebildet ist.

9. Bedieneinrichtung nach einem der Ansprüche 1 bis 8,
**dadurch gekennzeichnet, dass**
die Bedieneinrichtung (10) eine Mehrzahl der Bedienelemente (12) aufweist, welchen ein jeweiliger Aktor (22) zugeordnet ist, wobei die Bedienelemente (12) in wenigstens einer Reihe angeordnet sind.

10. Verfahren zum Ansteuern von Funktionseinheiten eines Kraftfahrzeugs, bei welchem wenigstens ein Bedienelement (12) einer Bedieneinrichtung (10) von einer Bedienperson bewegt wird, bei welchem ein an dem Bedienelement (12) festgelegter Anker (20) eines Aktors (22) der Bedieneinrichtung (10) durch das Bewegen des Bedienelements (12) bewegt wird, wobei mittels einer Auswerteeinrichtung (36) der Bedieneinrichtung (10) eine Position des Ankers (20) relativ zu einem Spulenelement (28) des Aktors (22) erfasst wird, wobei mittels der Auswerteeinrichtung (36) ein Stromfluss durch das Spulenelement (28) eingestellt wird, welcher geringer ist als ein zum Bewegen des Ankers (20) einzustellender Stromfluss, wobei mittels der Auswerteeinrichtung (36) eine im Bereich des Spulenelements (28) vorhandene magnetische Flussdichte erfasst wird, und bei welchem der Bedienperson ein Betätigen des Bedienelements (12) mittels des Aktors (22) kommuniziert wird, indem der Anker (20) relativ zu dem Spulenelement (28) bewegt wird.

## Claims

1. Operator control device for actuating functional units of a motor vehicle, comprising at least one operating element (12) which can be moved by an operator, and an actuator (22) by means of which an actuation of the operator control (12) element can be communicated to the operator, wherein the actuator (22) comprises a coil element (28) and an armature (20) which can be moved relative to the coil element (28),
wherein the armature (20) is secured to the operating element (12) and the operator control device (10) comprises an evaluation apparatus (36) by means of which a position of the armature (20) relative to the coil element (28) can be detected,
**characterised in that**
the evaluation apparatus (36) is designed to set a current flow through the coil element (28) which is lower than a current flow to be set in order to move the armature (20), wherein the evaluation apparatus (36) is designed to detect a magnetic flux density present in the region of the coil element (28).

2. Operator control device according to claim 1,
**characterised in that**
the armature (20) is formed at least in some regions from a magnetic and/or magnetisable material, wherein the evaluation apparatus (36) is designed to detect a current flow through the coil element (28).

3. Operator control device according to claim 1 or 2,
**characterised in that**
the evaluation apparatus (36) is designed to set a pulsed current flow through the coil element (28).

4. Operator control device according to any of claims 1 to 3,
**characterised in that**
the evaluation apparatus (36) is designed to determine an actuating force which the operator applies in order to move the operating element (12).

5. Operator control device according to any of claims 1 to 4,
**characterised by**
a control device (38) to actuate the actuator (22) based on a signal from the evaluation apparatus (36).

6. Operator control device according to claim 5 in its dependence on claim 4, **characterised in that**
the control device (38) is designed to actuate the actuator (22) when the actuating force is greater than a predetermined threshold value of the actuating force.

7. Operator control device according to any of claims 1 to 6,
**characterised in that**
the coil element (28) is arranged on one side (34) of a printed circuit board (32) which is facing a side (24) of the operating element (12) to which the armature (20) is secured.

8. Operator control device according to claim 7,
**characterised in that**
the coil element (28) is formed by conductor tracks integrated into the printed circuit board (32).

9. Operator control device according to any of claims 1 to 8,
**characterised in that**
the operator control device (10) comprises a plurality of operating elements (12) with which a respective actuator (22) is associated, wherein the operating elements (12) are arranged in at least one row.

10. Method for actuating functional units of a motor vehicle, in which at least one operating element (12) of an operator control device (10) is moved by an operator and in which an armature (20), which is secured to the operating element (12), of an actuator (22) of the operator control device (10) is moved by the movement of the operating element (12), wherein a position of the armature (20) relative to a coil element (28) of the actuator (22) can be detected by means of an evaluation apparatus (36) of the operator control device (10), wherein a current flow through the coil element (28), which is lower than a current flow to be set in order to move the armature (20), is set by means of the evaluation apparatus (36), wherein a magnetic flux density present in the region of the coil element (28) is detected by means of the evaluation apparatus (36), and in said method an actuation of the operating element (12) by means of the actuator (22) is communicated to the operator by movement of the armature (20) relative to the coil element (28).

## Revendications

1. Appareil de commande permettant de commander des unités fonctionnelles d'un véhicule automobile, avec au moins un élément de commande (12) pouvant être mis en mouvement par un opérateur, et avec un actionneur (22) au moyen duquel un actionnement de l'élément de commande (12) peut être signalé à l'opérateur, dans lequel l'actionneur (22) comprend un élément formant bobine (28) et un induit (20) pouvant être mis en mouvement par rapport à l'élément formant bobine (28), dans lequel l'induit (20) est fixé au niveau de l'élément de commande (12) et l'appareil de commande (10) comprend un appareil d'évaluation (36) au moyen duquel une position de l'induit (20) par rapport à l'élément formant bobine (28) peut être détectée,
**caractérisé en ce que**
l'appareil d'évaluation (36) est conçu pour établir à travers l'élément formant bobine (28) un flux de courant inférieur à un flux de courant à établir pour mettre l'induit (20) en mouvement, dans lequel l'appareil d'évaluation (36) est conçu pour détecter une densité de flux magnétique présente dans la région de l'élément formant bobine (28).

2. Appareil de commande selon la revendication 1,
**caractérisé en ce que**
l'induit (20) est au moins partiellement formé d'un matériau magnétique et/ou pouvant être magnétisé, dans lequel l'appareil d'évaluation (36) est conçu pour détecter un flux de courant circulant à travers l'élément formant bobine (28).

3. Appareil de commande selon la revendication 1 ou 2,
**caractérisé en ce que**
l'appareil d'évaluation (36) est conçu pour établir un flux de courant cadencé à travers l'élément formant bobine (28).

4. Appareil de commande selon l'une quelconque des revendications 1 à 3, **caractérisé en ce que**
l'appareil d'évaluation (36) est conçu pour déterminer une force d'actionnement que l'opérateur applique pour mettre en mouvement l'élément de commande (12).

5. Appareil de commande selon l'une quelconque des revendications 1 à 4,
**caractérisé par**
un appareil de commande (38) permettant de commander l'actionneur (22) en fonction d'un signal de l'appareil d'évaluation (36).

6. Appareil de commande selon la revendication 5, en ce qu'elle se réfère à la revendication 4,
**caractérisé en ce que**
l'appareil de commande (38) est conçu pour commander l'actionneur (22) lorsque la force d'actionnement est supérieure à une valeur de seuil prédéterminée de la force d'actionnement.

7. Appareil de commande selon l'une quelconque des revendications 1 à 6,
**caractérisé en ce que**
l'élément formant bobine (28) est agencé sur un côté (34) d'une carte de circuit imprimé (32) faisant face à un côté (24), au niveau duquel l'induit (20) est fixé, de l'élément de commande (12).

8. Appareil de commande selon la revendication 7,
**caractérisé en ce que**
l'élément formant bobine (28) est formé de pistes conductrices intégrées dans la carte de circuit imprimé (32).

9. Appareil de commande selon l'une quelconque des revendications 1 à 8,
**caractérisé en ce que**
l'appareil de commande (10) comprend une pluralité d'éléments de commande (12) auxquels est associé un actionneur (22) respectif, dans lequel les éléments de commande (12) sont agencés selon au moins une rangée.

10. Procédé de commande d'unités fonctionnelles d'un véhicule automobile, lors duquel au moins un élément de commande (12) d'un appareil de commande (10) est mis en mouvement par un opérateur, lors duquel un induit (20), fixé à l'élément de commande (12), d'un actionneur (22) de l'appareil de commande (10) est mis en mouvement grâce à la mise en mouvement de l'élément de commande (12), dans lequel une position de l'induit (20) par rapport à un élément formant bobine (28) de l'actionneur (22) est détectée au moyen d'un appareil d'évaluation (36) de l'appareil de commande (10), dans lequel un flux de courant inférieur à un flux de courant à établir pour mettre en mouvement l'induit (20) est établi à travers l'élément formant bobine (28) au moyen de l'appareil d'évaluation (36), dans lequel un flux magnétique présent dans la région de l'élément formant bobine (28) est détecté au moyen de l'appareil d'évaluation (36), et dans lequel un actionnement de l'élément de commande (12) est signalé à l'opérateur au moyen de l'actionneur (22) tandis que l'induit (20) est mis en mouvement par rapport à l'élément formant bobine (28).
